(19) Europäisches Patentamt
European Patent Office
Office européen des brevets

(11) **EP 4 645 179 A2**

(12) **EUROPEAN PATENT APPLICATION**

(43) Date of publication:
**05.11.2025 Bulletin 2025/45**

(21) Application number: **25203197.6**

(22) Date of filing: **10.02.2023**

(51) International Patent Classification (IPC):
*G06N 10/40* *(2022.01)*

(52) Cooperative Patent Classification (CPC):
**G06N 10/40; H01L 23/49838; H01L 23/49888;**
**H01L 25/0657; H10N 60/0241; H10N 69/00**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **11.02.2022 NL 2030907**

(62) Document number(s) of the earlier application(s) in
accordance with Art. 76 EPC:
**23703494.7 / 4 477 042**

(71) Applicant: **QuantWare Holding B.V.**
**2628 XG Delft (NL)**

(72) Inventors:
• **BRUNO, Alessandro**
**2628 XG Delft (NL)**
• **VLAAR, Sophia**
**2628 XG Delft (NL)**
• **RIJLAARSDAM, Matthijs**
**2628 XG Delft (NL)**

(74) Representative: **Hoyng Rokh Monegier B.V.**
**Rembrandt Tower, 30th Floor**
**Amstelplein 1**
**1096 HA Amsterdam (NL)**

Remarks:
This application was filed on 18.09.25 as a divisional
application to the application mentioned under INID
code 62.

(54) **QUANTUM COMPUTING APPARATUS WITH INTERPOSER AND METHODS OF FABRICATION AND OPERATION THEREOF, QUANTUM COMPUTING APPARATUS COMPRISING TANTALUM NITRIDE AND METHOD OF FABRICATION THEREOF**

(57) The present invention discloses a a quantum computing apparatus. The quantum computing apparatus comprises a substrate layer and a patterned layer adjacent and parallel to the substrate layer such that the substrate layer and the patterned layer form a layer stack. The patterned layer comprises an electrically conductive material. The layer stack forms multiple qubits. The quantum computing apparatus further comprises an interposer comprising a rigid connection element mechanically connected to the layer stack, wherein the connection element is substantially planar and positioned in a non-parallel plane to the plane in which the substrate layer is formed, and wherein the connection element comprises a conductive element formed on or in the connection element, preferably a transmission line, for providing an electrical connection to the patterned layer.

## Description

TECHNICAL FIELD

This disclosure generally relates to the field of quantum computing. More specifically, but not exclusively, it relates to a quantum computing apparatus making use of an interposer. Furthermore, the invention relates to a quantum computing apparatus comprising tantalum nitride.

BACKGROUND

Quantum computing uses properties of quantum states, such as superposition, interference, and entanglement, to perform computational tasks by executing quantum algorithms. In some quantum computing architectures, these quantum algorithms are executed on quantum processors comprising superconducting qubits.

A qubit or quantum bit is a two-state (or two-level) quantum-mechanical system, one of the simplest quantum systems displaying the properties of quantum states. The general quantum state of a qubit can be represented by a linear superposition of its two orthonormal basis states: $|0\rangle$ and $|1\rangle$.

There exists a variety of superconducting qubit implementations into specific physical systems. The three superconducting qubit archetypes are the phase-, charge- and flux qubits, though many hybridizations exist. For any qubit implementation, the basis states are to be mapped to the different states of the physical system, typically to the quantized energy levels of the physical system, or to their quantum superpositions.

There exists other quantum computing architectures, for example comprising spin qubits. These are called spin qubit quantum computers. Their function is based on controlling the spin of charge carriers in semiconductor devices. The charge carriers can be electrons and electron holes.

Superconducting qubits and spin qubits are examples of promising technologies within the field of quantum computing. There are, however, a number of technical challenges in building a large-scale quantum computer. For example, a practical quantum computer needs to be physically scalable, i.e. to achieve useful quantum computation in the future both the number and quality of qubits in a quantum processor must scale up considerably.

The most fundamental challenge facing the task of getting quantum computers to scale is the fragility of qubits. **In** order to successfully execute a computation, all qubits must be kept in a quantum coherent state. Quantum coherence refers to the ability of a quantum state to maintain its entanglement and superposition in the face of interactions and the effects of thermalization. Any environmental interference in the quantum system usually produces what is known as decoherence, i.e. the loss of quantum coherence. Decoherence is irreversible and results in a loss of information, since the qubits 'collapse' or fall out of a state of superposition which thus results in a loss of the wanted quantum state. These environmental interferences, known as noise, include the slightest variance in vibration, radiation, electromagnetic waves or temperature.

A considerable bottleneck to scaling up the number of qubits in a quantum processor is caused by spatial issues associated with the current two-dimensional quantum processor architectures.

Firstly, lateral wirebonds give rise to a lack of space at the chip-edge, as the chip edges scale linearly whereas the area for the placement of chip elements scales quadratically. Thus, as more qubits are implemented in a quantum processor, the surface area taken up by the chip elements increases faster than the perimeter of the chip, leading to situations where there is not enough space at the edges of the chip to accommodate wirebonding to all qubits.

Secondly, the necessity of routing the waveguides to the edges of the chip lead to on-chip routing issues as the chip elements increase quadratically.

Thirdly, up-chain fan-out of wires and other components also create spatial issues.

A partial solution for the first two of the above mentioned bottlenecks is represented by the prior art document EP 3 427 310 B1 to allow for each interconnect to be placed in close proximity to the relative qubit, not necessitating routing to the edges of the chip and allowing for a repeatable and tileable layout. This solution alone is not sufficient, as a suitable technology to continue the waveguides in a scalable way, without incurring fan-out issues, was not provided.

In an exemplary case of a particular design choice for superconducting qubits on average around 2.5 transmission lines per qubit are necessary as each qubit needs access to microwave drive, flux bias and an input/output feedline. The input/output feedline can possibly be shared between qubits. The transmission lines are usually routed towards the edges of the chip where the signal is continued to connectors placed on the printed circuit board through wirebonds. In case of a small amount of qubits, this is still a feasible option. However, when scaling up the number of qubits on a chip this results in spatial issues at the chip edge due to connector size and on-chip routing difficulties.

In the case of spin qubits, a large plurality of low frequency gates is required. For scaling up the number of spin qubits on a chip, the spatial issues are therefore even more pressing than for superconducting qubits.

A second bottleneck in the creation of quantum processors with high qubit counts is caused by the fact that the probability of all qubits working on a particular chip (in other words, chip yield) decreases exponentially with the number of qubits.

Another technical challenge in building a practical quantum computer is that to achieve useful quantum computation, qubits need to be of significant quality in order to avoid errors. One measure of high quality qubits is long decoherence times, i.e. the time it takes for a qubit to lose its quantum coherent state. Time-consuming tasks (longer than the decoherence times of the qubits that need to perform the task) may be difficult to perform using certain quantum algorithms, as maintaining the state of superposition of qubits for a long enough duration will eventually result in those qubits collapsing due to decoherence. For this reason, ways to increase decoherence times are currently a major topic of research.

SUMMARY

To address the above discussed drawbacks of the prior art, there is proposed, according to a first aspect of the disclosure, a quantum computing apparatus. The quantum computing apparatus comprises a substrate layer; a patterned layer adjacent and parallel to the substrate layer such that the substrate layer and the patterned layer form a layer stack, wherein the patterned layer comprises an electrically conductive material and forms at least part of a quantum computing circuit component; and an interposer comprising a substantially rigid connection element mechanically connected to the layer stack and positioned in a non-parallel plane, i.e. positioned in a plane which is not parallel to the plane in which the substrate layer is formed, and a conductive element formed on or in the connection element for providing an electrical connection to the patterned layer. The substantially rigid connection element is preferably positioned in a plane which is substantially orthogonal to the plane in which the substrate layer of the layer stack is formed. The conductive element is preferably a transmission line formed on or in the connection element. The quantum computing apparatus preferably comprises a plurality of computing circuit components, and a plurality of interposers comprising a plurality of connection elements.

In one embodiment, the connection element is substantially planar, preferably wherein the connection element is of substantially rectangular or square shape.

In one embodiment, the interposer is electrically connected to the patterned layer, wherein the electrical connection is made galvanically, inductively and/or capacitively between the connection element and the patterned layer.

In one embodiment, the substrate layer is made from or includes sapphire, silicon, BeO, AlN, quartz, and/or other dielectric material, and/or wherein the patterned layer is made from or includes a superconducting material such as Al, Nb, NbN, NbTiN, tantalum, or preferably tantalum nitride, or a combination of these materials.

In one embodiment, the patterned layer is formed at least in part by atomic layer deposition, evaporation, molecular-beam epitaxy and/or sputtering.

In one embodiment, the connection element is made at least in part from the same material used for the substrate layer, and the complete interposer may also be made at least in part of this material.

In one embodiment, the quantum computing circuit component comprises a qubit, a photonic quantum circuit, and/or a chip element associated with a qubit or photonic quantum circuit, preferably control electronics, readout circuit, amplifiers, filters and/or a transducer. The qubit preferably comprises a superconducting qubit, a spin qubit, a trapped ion qubit, or a neutral atom qubit. The quantum computing circuit component may comprise a plurality of qubits, photonic quantum circuits, and associated chip elements.

In one embodiment, the connection element further comprises a functional element, the functional element being a circuit component which receives input from and/or sends output to the quantum computing circuit component, preferably wherein the functional element comprises a low pass filter, an attenuator, a DC-block, an IR filter, a directional coupler, a circulator, and/or an amplifier.

In one embodiment, the connection element has at least one of the following functions: microwave drive, flux bias, feedline input/output, pump for amplifiers or circulators, parametric amplifier, circulator, directional coupler or routing lines.

In one embodiment, routing of inputs and/or outputs to and/or from the quantum computing circuit component is at least partly done via the connection element.

In one embodiment, the interposer is connected directly to the patterned layer, or wherein the interposer is connected indirectly to the patterned layer, preferably through a via.

In one embodiment, the connection element and the layer stack each have a connection surface with a connection profile for mechanically and/or electrically coupling the connection element to the layer stack, preferably wherein the connection surface of the layer stack is an outermost layer of the layer stack, more preferably wherein the connection surface of the layer stack is the patterned layer, preferably wherein the connection profile comprises a coupling structure, preferably a recess, a protrusion, a coupling pin; preferably wherein the coupling structure is self-aligning.

In one embodiment, the connection profile formed on the connection surface is created using a lithography process, deep reactive etching and/or photoablation.

In one embodiment, the quantum computing apparatus further comprises a connectable circuit component, wherein the connection element is an intermediate link between the layer stack, preferably the quantum computing circuit component, and the connectable circuit component; preferably wherein the connectable circuit component comprises a connectorized circuit, more preferably a printed circuit board or an array of waveguides.

In one embodiment, the connectable circuit component comprises a second layer stack, formed by at least a second substrate layer and a second patterned layer adjacent and parallel to the second substrate layer, wherein the second patterned layer forms at least one second quantum computing circuit component.

In one embodiment, the second layer stack is substantially parallel to the layer stack and at an angle, preferably substantially orthogonal, to the connection element, preferably wherein the second layer stack is positioned in substantially the same plane as the layer stack and wherein the layer stack and the second layer stack are electrically connected via routing lines in the interposer; or wherein the second layer stack is positioned in a different plane than the plane in which the layer stack is positioned, the connection element reaching from the plane in which the layer stack is positioned to the plane where the second layer stack is positioned.

In one embodiment, the connectable circuit component comprises, preferably wherein the second quantum computing circuit comprises, a qubit and/or other chip elements, preferably control electronics, readout circuit or transducers.

In one embodiment, the interposer comprises an array of connection elements which are substantially parallel to each other and at an angle, preferably substantially orthogonal, to the layer stack and wherein each connection element of the array is connected to the patterned layer, preferably wherein the connection elements are spaced with a particular spacing related to the spacing of the qubits on the horizontal plane.

In one embodiment, the layer stack comprises multiple patterned layers, each patterned layer comprising a quantum computing circuit component.

In one embodiment, the layers in the layer stack and/or layers in the connection element are connected through through-silicon via, preferably wherein the layer stack and/or the connection element comprises a through via and/or a blind via.

In one embodiment, a second interposer is mechanically connected to the layer stack at an opposite end of the layer stack of where the interposer is mechanically connected to the layer stack, preferably wherein the input feedlines of the patterned layer are provided via the interposer, and the output feedlines of the patterned layer are provided via the second interposer.

In one embodiment, multiple interposers are mechanically and electrically connected to a connection surface of the layer stack, and/or wherein multiple layer stacks are alternated with interposers.

According to a second aspect of the disclosure, a method of performing a quantum computing operation is disclosed, using a quantum computing apparatus according to the first aspect of the disclosure.

According to a third aspect of the disclosure, a method of fabricating a quantum computing apparatus is disclosed. The method comprises providing a substrate; depositing a patterned layer on top of the substrate layer and parallel to the substrate layer such that the substrate layer and the patterned layer form a layer stack, wherein the patterned layer comprises an electrically conductive material and forms at least part of one quantum computing circuit component; mechanically connecting a substantially rigid connection element comprised in an interposer to the layer stack, positioned in a non-parallel plane, preferably being substantially orthogonal, to the plane in which the substrate layer is formed; forming a conductive element on or in the connection element, preferably a transmission line, for providing an electrical connection to the patterned layer; and electrically coupling the conductive element to the patterned layer.

According to a fourth aspect of the disclosure, a quantum computing apparatus is disclosed. The quantum computing apparatus comprises a substrate layer; a patterned layer adjacent and parallel to the substrate layer such that the substrate layer and the patterned layer form a layer stack, wherein the patterned layer comprises an electrically conductive material and forms at least one quantum computing circuit component; wherein the electrical conductive material comprises tantalum nitride.

In one embodiment, the substrate layer is made from sapphire, silicon, BeO, AlN, quartz, and/or any other dielectric material; and/or wherein the quantum computing circuit component comprises a qubit, preferably a superconducting qubit or a spin qubit.

According to a fifth aspect of the disclosure, a method of fabricating a quantum computing apparatus is disclosed. The method comprises providing a substrate layer; depositing a patterned layer on top of the substrate layer using atomic layer deposition and/or sputtering with tantalum nitride, such that the patterned layer comprises tantalum nitride and forms at least one quantum computing circuit component, preferably a qubit, more preferably a superconducting qubit or a spin qubit; wherein preferably the substrate layer is made from sapphire, silicon, BeO, AlN, quartz, and/or any other dielectric material.

According to a sixth aspect of the disclosure, a quantum computing apparatus is disclosed. The quantum computing apparatus comprises a substrate layer and a patterned layer adjacent and parallel to the substrate layer such that the substrate layer and the patterned layer form a layer stack. The patterned layer may comprise an electrically conductive material and the layer stack may form multiple qubits.

The quantum computing apparatus further comprises an interposer comprising a connection element mechanically connected to the layer stack, wherein the connection element may be substantially planar and positioned in a non-parallel plane to the plane in which the substrate layer is formed. The connection element may comprise a conductive element formed on or in the connection element, preferably a transmission line, for providing an electrical connection to the patterned layer. The connection element may be rigid.

In one embodiment, the connection element may be of substantially rectangular or square shape.

In one embodiment the interposer is electrically connected to the patterned layer galvanically, inductively or capacitively.

In one embodiment the substrate layer is made from sapphire, silicon, BeO, AlN, quartz, and/or any other dielectric material, and/or wherein the patterned layer is made from a superconducting material such as Al, Nb, NbN, NbTiN, tantalum, preferably tantalum nitride.

In one embodiment the patterned layer is formed by atomic layer deposition, evaporation, molecular-beam epitaxy and/or sputtering.

In one embodiment interposer, preferably the connection element, is made from the same material as used for the substrate layer.

In one embodiment the connection element, comprises a connection substrate layer, or a connection substrate layer and a connection patterned layer adjacent and parallel to the connection substrate layer wherein the connection patterned layer comprises an electrically conductive material

The connection substrate layer may be made from sapphire, silicon, BeO, AlN, quartz, and/or any other dielectric material. The connection patterned layer may be made from a superconducting material such as Al, Nb, NbN, NbTiN, tantalum, preferably tantalum. The connection patterned layer may be coated with a conductive layer.

In one embodiment the qubit may comprise a superconducting qubit, a spin qubit, a trapped ion, or a neutral atom. Additionally or alternatively, the patterned layer may further form a quantum computing circuit, wherein the quantum computing circuit comprises a photonic quantum circuit and/or another chip element, preferably control electronics, readout circuit, amplifiers, filters and/or a transducer.

In one embodiment the connection element may further comprise a functional element, the functional element being a circuit component which gets input from and/or sends output to the qubit and/or wherein the functional element modifies the input/output signal from the quantum computing circuit component, preferably wherein the functional element comprises a low pass filter, an attenuator, a DC-block, an IR filter, a directional coupler, a routing line, a circulator, and/or an amplifier.

In one embodiment the connection patterned layer may form the functional element.

The connection element may have at least one of the following functions: microwave drive, flux bias, feedline input/output, pump for the amplifier or circulator, parametric amplifier, circulator, directional coupler or routing lines.

In one embodiment routing to and/or from the qubit is at least partly done via the connection element.

In one embodiment the interposer is connected directly to the patterned layer, or wherein the interposer is connected indirectly to the patterned layer, preferably through a via.

In one embodiment the connection element and the layer stack each have a connection surface with a connection profile for mechanically and/or electrically coupling the connection element to the layer stack, preferably wherein the connection surface of the layer stack is an outermost layer of the layer stack, more preferably wherein the connection surface of the layer stack is the patterned layer, preferably wherein the connection profile comprises a coupling structure, preferably a recess, a protrusion, a coupling pin; preferably wherein the coupling structure is self-aligning.

In one embodiment the connection profile formed on the connection surface is created through lithography, deep reactive etching and/or photoablation.

In one embodiment the quantum computing apparatus may further comprise a connectable circuit component, wherein the connection element is an intermediate link between the layer stack, preferably the qubit, and the connectable circuit component; preferably wherein the connectable circuit component comprises a connectorized circuit, more preferably a printed circuit board or an array of waveguides.

In one embodiment the connectable circuit component comprises a second layer stack, formed by at least a second substrate layer and a second patterned layer adjacent and parallel to the second substrate layer, wherein the second patterned layer forms at least one quantum computing circuit component.

In one embodiment the second layer stack is substantially parallel to the layer stack and at an angle, preferably substantially orthogonal, to the connection element. Preferably, the second layer stack is positioned in substantially the same plane as the layer stack. The layer stack and the second layer stack may be electrically connected via routing lines in the interposer. It may also be that the second layer stack is positioned in a different plane than the plane in which the layer stack is positioned, and the connection element may then reach from the plane in which the layer stack is positioned to the plane where the second layer stack is positioned.

In one embodiment the connectable circuit component comprises, preferably wherein the second quantum computing circuit comprises, a qubit and/or other chip elements, preferably control electronics, readout circuit or transducers.

In one embodiment the interposer comprises an array of connection elements which are substantially parallel to each other and at an angle, preferably substantially orthogonal, to the layer stack and wherein each connection element of the array is connected to the patterned layer, preferably wherein the connection elements are spaced with a particular spacing related to the spacing of the qubits on the horizontal plane.

In one embodiment, the interposer comprises at least one spacer element. Preferably the connection elements are aligned by the at least one spacer element. The spacer element may be mechanically connected to the connection element and/or the layer stack, preferably through a through-silicon via. The at least one spacer element may be positioned in a non-parallel plane to the substrate plane of the layer stack, preferably a substantially orthogonal plane to the substrate plane of the layer stack, more preferably wherein the spacer element is positioned in a plane parallel to the one or more connection elements. Preferably the interposer comprises multiple spacers, more preferably the multiple spacers may be alternating with the connection elements, not necessarily one-to-one.

In one embodiment the at least one spacer comprises a spacer substrate layer, or a spacer substrate layer and a spacer patterned layer adjacent and parallel to the spacer substrate layer wherein the spacer patterned layer comprises an electrically conductive material. The spacer substrate layer may be made from sapphire, silicon, BeO, AlN, quartz, and/or any other dielectric material. Preferably the spacer patterned layer is made from a superconducting material such as Al, Nb, NbN, NbTiN, tantalum, preferably tantalum nitride. The spacer patterned layer may further be coated with a conductive layer.

In one embodiment the at least one spacer comprises a functional spacer element. Preferably the functional spacer element comprises a shield and/or the at least one spacer can comprise a waveguide with the connectable circuit component, for example a PCB.

In one embodiment the layer stack comprises multiple patterned layers deposited on one or more substrate layers, each patterned layer comprising a quantum circuit component, preferably a qubit.

In one embodiment the layers in the layer stack and/or layers in the connection element are connected through through-silicon via. Preferably the layer stack and/or the connection element comprises a through via and/or a blind via.

In one embodiment a second interposer is mechanically connected to the layer stack at an opposite end of the layer stack of where the interposer is mechanically connected to the layer stack. Preferably the input feedlines of the patterned layer are provided via the interposer, and/or the output feedlines of the patterned layer are provided via the second interposer.

In one embodiment multiple interposers are mechanically and electrically connected to a connection surface of the layer stack, and/or multiple layer stacks are alternated with interposers.

In a seventh aspect, a method of performing a quantum computing operation according to the sixth aspect is disclosed, using a quantum computing apparatus according to the sixth aspect of the invention.

In an eighth aspect, a method of fabricating a quantum computing apparatus is disclosed. The method comprises providing a substrate; depositing a patterned layer on top of the substrate layer and parallel to the substrate layer such that the substrate layer and the patterned layer form a layer stack, wherein the patterned layer comprises an electrical conductive material and wherein the layer stack forms multiple qubits; mechanically connecting a connection element comprised in an interposer to the layer stack, positioned in a non-parallel plane, preferably being substantially orthogonal, to the plane in which the substrate layer is formed; forming a conductive element on or in the connection element, preferably a transmission line, for providing an electrical connection to the patterned layer; and electrically coupling the conductive element to the patterned layer. The connection element may be rigid and/or substantially planar.

BRIEF DESCRIPTION OF DRAWINGS

Embodiments will now be described, by way of example only, with reference to the accompanying schematic drawings in which corresponding reference symbols indicate corresponding parts, and in which:

FIG. 1 schematically shows a part of a quantum computing apparatus comprising a layer stack with an interposer positioned thereon according to an embodiment;
FIG. 2 schematically shows a perspective view of a part of a quantum computing apparatus comprising a layer stack with an interposer comprising an array of connection elements positioned thereon according to an embodiment;
FIG. 3 schematically shows a perspective view of how one or multiple quantum computing circuit components, preferably qubits, can be electrically connected to a connection element in a part of a quantum computing apparatus according to an embodiment;
FIG. 4 schematically shows a part of a quantum computing apparatus comprising a connection element comprising transmission lines and one or multiple functional elements according to an embodiment;
FIG. 5 schematically shows a perspective view of a part of a quantum computing apparatus comprising a layer stack with an interposer comprising an array of connection elements with transmission lines and one or multiple functional elements positioned thereon according to an embodiment;
FIG. 6 schematically shows a perspective view of a part of a quantum computing apparatus comprising two layer stacks with an interposer formed in-between.
FIG. 7 schematically shows a part of a quantum computing apparatus comprising a layer stack with two interposers positioned thereon on either side of the layer stack according to an embodiment.
FIG. 8 schematically shows a part of a quantum computing apparatus comprising mechanical and electrical connections between an connection element and a layer stack;
FIG. 9 schematically shows a part of a quantum computing apparatus comprising a modular structure with multiple planes comprising one or more quantum computing circuit components, preferably qubits;

FIG. 10 schematically shows a part of a quantum computing apparatus comprising an interposer which connects two layer stacks comprising one or more quantum computing circuit components, preferably qubits;

FIG. 11 schematically shows a part of a quantum computing apparatus comprising an interposer comprising an array of connection elements which connect multiple modules within an modular structure, each module comprising one or more quantum computing circuit components, preferably qubits;

FIG. 12 schematically depicts an interposer positioned on a layer stack comprising quantum computing circuit components, preferably qubits, wherein the interposer comprises connection elements and spacer elements;

FIGS. 13A and 13B respectively show the spacer connected on top of the vertical connection element or the spacer connected on top of another spacer;

FIG. 14 schematically shows a connection profile between the connection element and the layer stack comprising qubits.

The figures are meant for illustrative purposes only, and do not serve as restriction of the scope or the protection as laid down by the claims.

DESCRIPTION OF EMBODIMENTS

Hereinafter, certain embodiments will be described in further detail. It should be appreciated, however, that these embodiments may not be construed as limiting the scope of protection for the present disclosure.

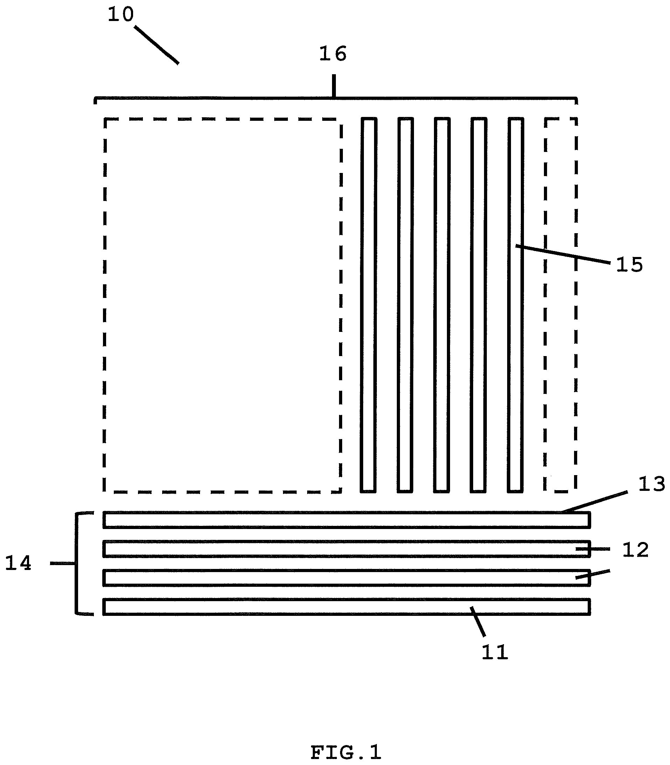

FIG. 1 schematically shows a part of a quantum computing apparatus 10 comprising a layer stack 14 with an interposer 16 positioned thereon according to an embodiment.

The layer stack 14 can comprise one or multiple substrate layers 11 and one or multiple patterned layers 12 wherein each of the patterned layers 12 comprises an electrical conductive material and wherein each of the patterned layers 12 and/or the layer stack 14 forms at least (a part of) one quantum computing circuit component, preferably one or more qubits. Transmission lines of the individual qubit planes of the stack can be connected through signal vias in the (vertically) adjacent horizontal planes possibly containing qubits. Instead of qubits, other quantum computing circuit components could be connected in this manner.

The one or more substrate layer 11 can be made, for example, from sapphire, silicon, BeO, AlN, quartz, and/or any other dielectric material. Each of the substrate layers 11 can be different in thickness and/or material. The one or more patterned layers 12 can be made from a superconducting material such as Al, Nb, NbN, NbTiN, tantalum, preferably tantalum nitride. The patterned layer is formed by atomic layer deposition, evaporation, molecular-beam epitaxy and/or sputtering. Layer stack spacing elements can also be present between different layers of the layer stack wherein the quantum computing circuit component is formed. An adjacent layer can be directly adjacent, or different layers can lie in-between.

The quantum computing circuit component can be a qubit, preferably a superconducting qubit, a spin qubit, trapped ion or a neutral atom; a photonic quantum computing circuit; and/or another chip element, preferably control electronics, amplifiers, filters or a transducer. The chip element can be used to control the functionality of a qubit of the quantum computing apparatus 10.

The multiple layers of the layer stack 14 are formed on top of each other so as to be substantially parallel. The layer stack 14 of the quantum computing apparatus 10, e.g. a quantum processor, may thus e.g. comprise one or more qubit planes consisting of a 2D (or 3D cavity) substrate layer 11 and one or more adjacent patterned layers 12 containing qubits, possibly with one or more extra layers in between the substrate plane and the patterned layer.

While the layer stack 14 can comprise a substrate layer 11 and one or more adjacent patterned layers 12, the layer stack can also comprise multiple substrate layers. For example, the layer stack 14 can comprise multiple horizontal chip layers, which may or may not be operatively connected to each other. The horizontal chip layers do not have to directly touch one another directly at every position along the chip layer, but can be spaced apart.

An interposer 16 comprising one or multiple connection elements 15 can be mechanically connected to the layer stack 14. The interposer 16 provides an electrical connection from one or multiple quantum computing circuit components, preferably qubits, formed on one or multiple of the patterned layers 12 to a different part of the quantum computing apparatus. The interposer can be electrically connected to the layer stack 14 (and preferably one or multiple patterned layers 12 formed therein) in various ways, for example galvanically, inductively and/or capacitively.

The one or multiple connection elements 15 can be positioned in a plane substantially orthogonal to the plane in which the substrate layer of the layer stack 14 (comprising the quantum computing circuit component, preferably a qubit) is formed. In general, the one or multiple connection elements 15 can be positioned in a plane which is non-parallel to the plane in which the substrate layer is formed. A conductive element can be formed on or in the connection element, preferably a transmission line, for providing an electrical connection to one or multiple of the patterned layers 12. The connection elements are thus so placed to provide an electrical connection to the one or multiple quantum computing circuit components, preferably qubits, formed on one or multiple of the patterned layers 12. This electrical connection can be done directly or indirectly, for example by forming the quantum computing circuit components on the outer layer of the layer stack facing the connection element and forming the electrical connection directly on the outer layer of the layer stack, or by forming the quantum computing circuit components in an different layer of the layer stack and connect electrically via a VIA. The connection elements can be formed substantially parallel to each other, thus forming an array.

The connection elements 15 can be formed of one or multiple substrate layers and one or multiple patterned layers formed thereon. The connection elements 15 can be different from one another within the interposer 16. The thickness of a connection element 15 can be for example 200 $\mu$m to 1 mm. The connection elements 15 can comprise different kinds of via's, for example connecting different patterned layers within the connection element 15.

If the quantum computing circuit components, preferably qubits, are formed in an array in the layer stack, the connection elements can have a width at least equal to the width of a row of the quantum computing circuit component array. In this way, a single connection element can electrically connect to all quantum computing circuit components in a particular row. The number of rows of the quantum computing circuit component array can be equal to the number of connection elements. In this way, each row of the quantum computing circuit component array can be connected to a corresponding connection element. It is also possible that for example two or more connection elements are connected to the quantum computing circuit component in a particular row, or that for example two or more rows are connected to a single connection element.

The connection elements 15 can be rigid and not easy to bend because of the way the connection elements 15 are formed. Each connection element can comprise a connection substrate layer, or a connection substrate layer and a connection patterned layer adjacent and parallel to the connection substrate layer wherein the connection patterned layer comprises an electrically conductive material. Preferably, the connection substrate layer is made from sapphire, silicon, BeO, AlN, quartz, and/or any other dielectric material. The connection patterned layer is preferably made from a superconducting material such as Al, Nb, NbN, NbTiN, tantalum, more preferably tantalum nitride.

The connection element can be substantially planar, for example the connection element can be of substantial rectangular or square shape. Other shapes are also possible, for example the connection element can have a footprint with curved sections on the layer stack 14. The connection element can also be curved along its length. If multiple connection elements are placed on the layer stack 14, not all connection elements need to be placed parallel to each other on the layer stack 14 but they can for example lie in planes that intersect one another.

An outermost layer 13 of the layer stack 14 can function as a connection surface with one or multiple of the connection elements 15 of the interposer 16, having a connection profile for mechanically and electrically coupling an connection element 15 of an interposer 16 to the layer stack. Preferably the outermost layer 13 of the layer stack 14 is a patterned layer 12.

Preferably, the one or more connection elements 15 may be made of the same material as that of the substrate layer in the layer stack. The benefit of this would be having similar thermal contraction for both the layer stack 14 and the connection elements 15 of the processor.

The connection elements 15 are spaced apart such as to form an array. Since every quantum computing circuit component has e.g. transmission lines connected to it, dividing the connection elements 15 over the connection surface makes it possible to lead e.g. transmission lines away vertically via the connection elements 15 instead of horizontally via the layer stack 14.

To space the connection elements 15 of the interposer 16, the interposer 16 may further comprise one or multiple spacer elements. In this way, the connection elements forming the array of connection elements of the interposer 16 can be aligned by at least one spacer element. For example, between each pair of connection elements 15 forming the array of connection elements a spacer element can be placed, i.e., the spacer elements and the connection elements can alternate one after the other. It is also possible that multiple connection elements are formed between two subsequent spacer elements, or that multiple spacer elements are formed between two subsequent connection elements.

Each spacer element can be formed as a substantially planar structure, having a substantially square or rectangular shape. In particular, each spacer element can have substantially the same width and height as a connection element as specified above, but a connection element can also have e.g. a greater height than a spacer element. The planar structure of each spacer element can be formed in a non-perpendicular plane to the top surface of the layer stack 14, preferably perpendicular to the top surface of the layer stack 14. Furthermore, each spacer element can be formed parallel to the connection elements 15 in the array.

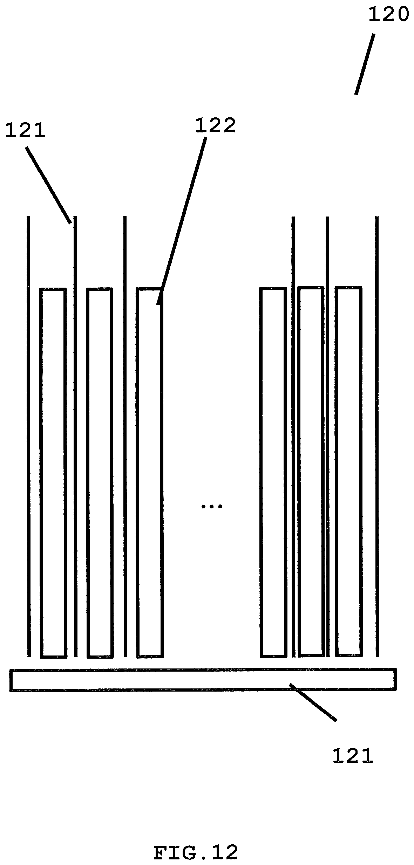

FIG. 12 schematically depicts a quantum computing apparatus 120 with an interposer positioned on a layer stack 121 comprising quantum computing circuit components, preferably qubits, wherein the interposer comprises connection elements 121 and spacer elements 122. The connection elements 121 can have greater height than the spacer elements 122, so the connection elements 121 can for example be connected to another connection board such as a PCB or flexible cables. The connection elements 121 can also have similar height as or smaller height than the spacer elements 122. The connection elements and spacer elements can have varying height. Spacer elements can alternate vertical connection elements, not necessarily one-on-one alternation, one can have a variety of spacer element dimension and number in one stack. The spacer elements and connections elements are glued and/or soldered on top of each other such that the recess in the spacer element covers the transmission line, e.g. a coplanar waveguide, that can be formed in the connection element and thus shields the signals. The spacers may include a specific connection profile, with e.g. finger-like structures, to form one ground with the ground of the substrate layer of the layer stack wherein e.g. the qubits are formed.

The spacer element can be substantially rigid and mechanically connected to a connection element and/or the layer stack, via for example glue or soldering. Preferably the electrical connection is made through a through via. Spacer can be in electrical connection with the ground of the layer stack wherein e.g. the qubits are formed.

Each spacer element can comprise a spacer substrate layer. Furthermore, each spacer element can comprise a spacer patterned layer adjacent and parallel to the spacer substrate layer. The spacer patterned layer can comprise an electrically conductive material.

Preferably the spacer substrate layer is made from or comprises sapphire, silicon, BeO, AlN, quartz, and/or any other dielectric material. Preferably the spacer patterned layer is made from or comprises a superconducting material such as Al, Nb, NbN, NbTiN, tantalum, preferably tantalum nitride. On the superconductive layers of the connection elements and/or spacer elements in the interposer, it is possible to form a conductive layer. Preferably, each spacer element comprises the same material as a connection element of the interposer.

Spacer elements do not need to be in functional contact with the qubits formed in the layer stack. The substrate layer of the spacer can also be patterned with a laser.

The dimensions of the spacer elements comprised in the interposer 16 can be the same, for example the width of all the spacer elements can be the same so that the connection elements are equally spaced apart throughout the array. It is also possible that the dimensions of the spacer elements comprised in the interposer 16 vary. For example, the width of a first spacer element placed between a first pair of connection elements can be different than the width of a second spacer element formed between a second pair of connection elements of the interposer 16.

Each spacer element can thus make sure that the connection elements 15 are spaced the correct distance and/or can provide structural stability to the connection elements 15 and the interposer 16.

A spacer element can comprise a functional spacer element. The functional spacer element is, for example, a shield. Also transmission lines, e.g. a waveguide can be formed in the spacer element. The functional spacer element is formed within or on the spacer element.

The shield can shield transmission lines on the adjacent connection elements of the interposer. The shield can be formed within the patterned layer of the spacer element and can be thus formed out of a superconducting material, optionally with a conductive coating.

The waveguide can be a waveguide for the transmission of higher frequencies, for example submillimetre waves with a wavelength between 1 millimetre and 100 micrometres, also called terahertz-radiation, i.e., electromagnetic radiation between microwaves and the far-infrared. The precise frequency of the waveguides is determined by the dimension of the recess.

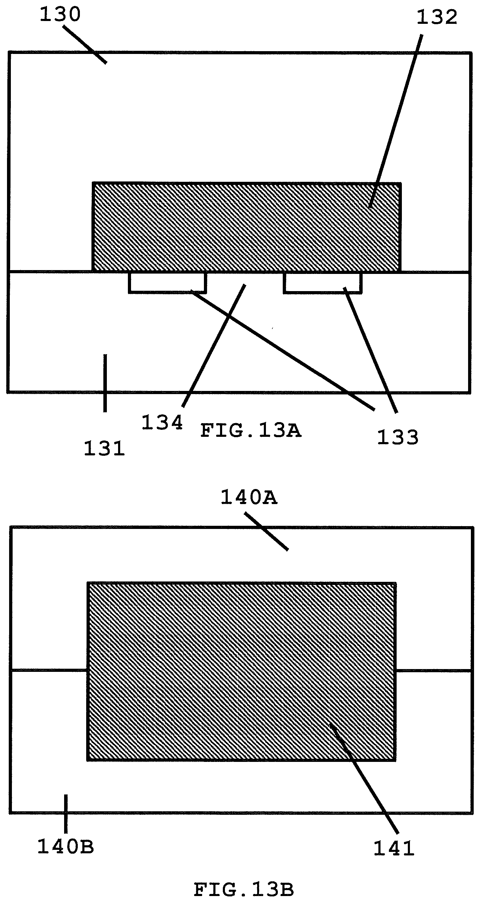

FIGS. 13A and 13B respectively show the spacer 130 connected on top of the vertical connection element 131 or the spacer 140A connected on top of another spacer 140B. The configuration in FIG. 13A is zoomed in on one of the transmission lines 134 and suited for transmissions with frequencies in the order of GHz. The signals are trapped in the cache or gap or vacuum 132 formed by the hatched/patterned pockets in the spacer 130, covered by superconducting and conducting material, thereby shielding the signal from "jumping" to other transmission lines. Reference numeral 133 denotes a gap between a transmission line and ground (like a coplanar waveguide). While a coplanar waveguide is shown in this figure, other waveguides are also possible. FIG. 13B shows two spacer elements 140A,140B forming a waveguide which is suited for transmission with frequencies in the order of THz. The signal is again trapped by the electrical cache in the gap/vacuum 141.

With this spacer design, the interposer is thus suited for readout of a wider range of frequencies.

The spacer and connection elements may be glued and/or soldered on top of each other such that the recess covers the co-planar waveguide located on the connection element in the patterned layer and shields the signals.

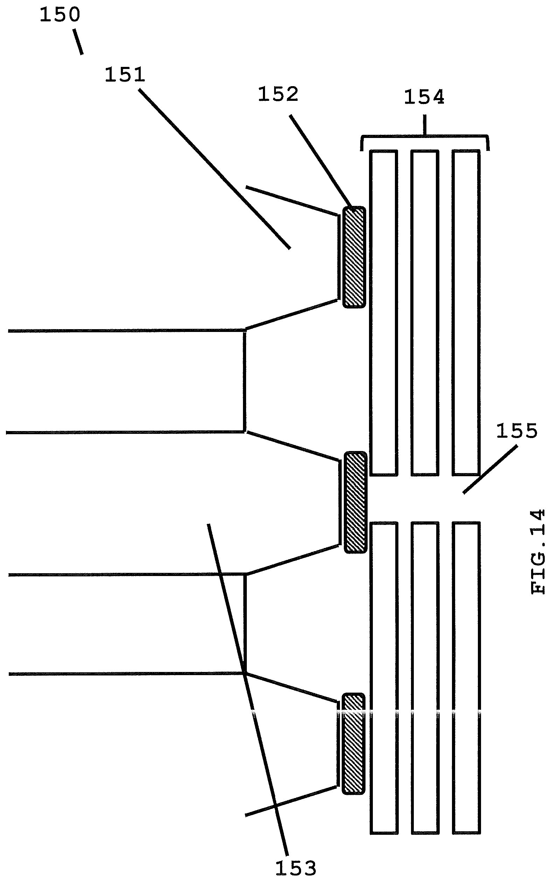

The spacer elements may have the same connection structure/profile as shown in FIG. 14, and may be in electrical contact with the ground of the layer stack forming the qubits. The spacer elements may include fingers to form one ground with the ground of the substrate layer.

Since the interposer 16, in particular the connection elements 15 can more easily be made longer than the height generally used for the layer stack 14, one has more degrees of freedom in the integration of in-line functional elements.

An interposer may thus comprise multiple connection elements, configured in an array formed along an array of e.g. qubits or other quantum circuit components in the layer stuck. The connection elements provide an electrical connection to and/or from the qubits or other quantum circuit components. Since the connection elements can be substantially planar structures they are easily manufactured and can be individualized to the needs of a particular row of qubits or other quantum circuit components. Furthermore, the space in between the connection elements can be more easily utilized by e.g. spacer elements with a specific design so as to for example shield the transmission lines that could be present in the (individualized) connection elements.

The quantum computing apparatus can further comprise one or more of the following: control hardware, preferably on-chip control elements, transductors, amplifiers, filters, circulators, wiring and a dilution refrigerator.

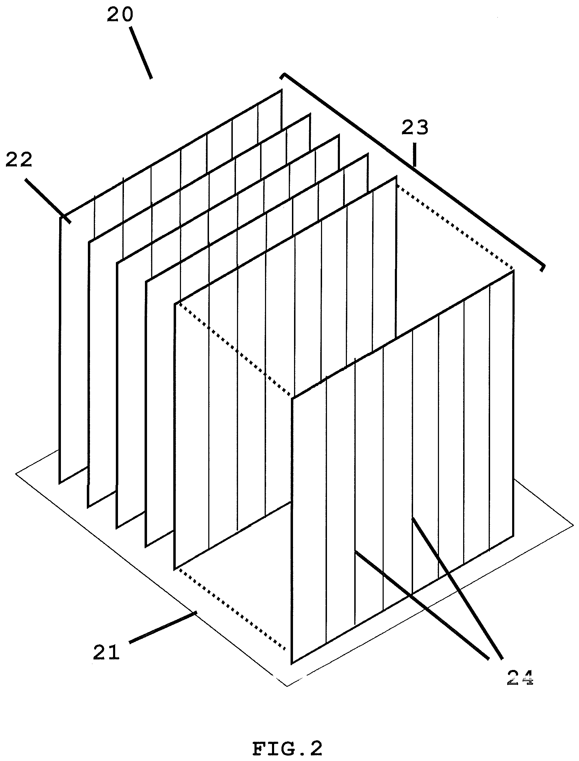

FIG. 2 schematically shows a perspective view of a part of a quantum computing apparatus 20 comprising a layer stack 21 with an interposer 23 comprising an array of connection elements 22 positioned thereon according to an embodiment.

In and/or on the connection elements 22, conductive elements can be patterned. For example, one or more transmission lines 24 can be formed in and/or on the connection elements 22. The transmission lines 24 provide an electrical connection to the layer stack, in particular the transmission lines 24 can provide an electrical connection to the patterned layers in the layer stack.

A transmission line 24 can be e.g. a patterned strip made of conductive material. For example, a normal conductor or a superconductor can be used if the quantum computing circuit component or the quantum computing apparatus requires this. Exemplary materials are indium, aluminium, gold and tin, which can be deposited on a surface of the substrate. Formation of this material can be done via evaporation, electroplating and/or sputtering. Patterning can be done by using a patterning technique such as for example wet etching, dry etching, lift-off, laser writing, milling, and/or screen printing.

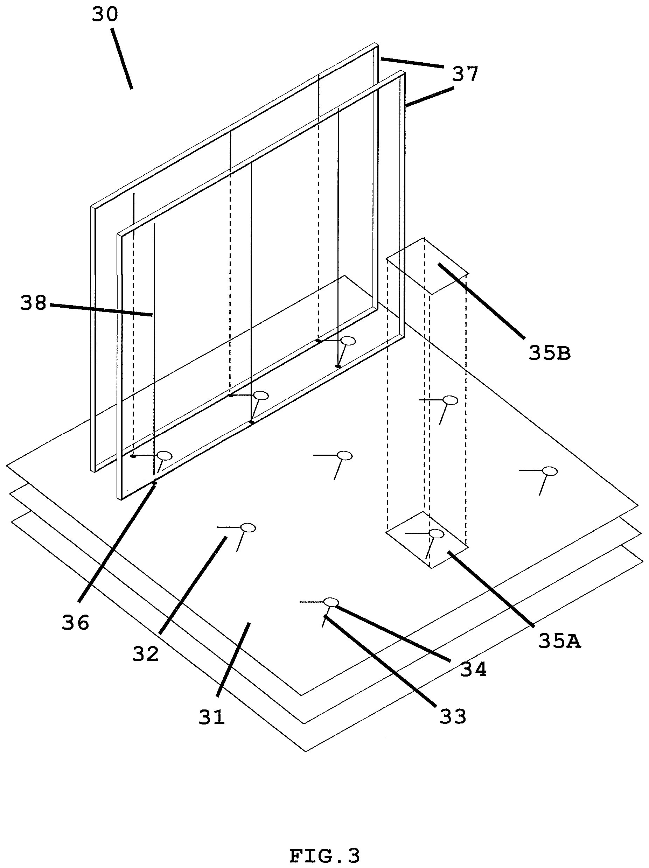

FIG. 3 schematically shows a perspective view of how one or multiple quantum computing circuit components 32 can be electrically connected to a connection element 37 of a part of a quantum computing apparatus 30 according to an embodiment.

The computing circuit component 32 as an example is shown as being a schematic representation of a superconducting qubit, having a qubit 34 with transmission line 33, e.g. a feedline. In the case of superconducting qubits on average around 2.5 transmission lines per qubit can be necessary as each qubit needs access to for example microwave drive, flux bias and an input/output feedline. The one or more quantum computing circuit components, e.g. qubits, can be formed in a two-dimensional array with equal spacing between components, or the spacing can be different between different components. The quantum computing circuit components are shown in the figure as a layer on top of the layer stack 31, however, these components can be formed anywhere in the layer stack 31 and on or in various layers within the layer stack 31. For example, not all components need to be formed within the same patterned layer of the layer stack 31, but they can be formed in or on different patterned layers of the layer stack 31. The layers in layer stack 31 can be connected to each other via through-silicon via.

The interposer containing an array of connection elements 37, which each can have its own function, (for example microwave drive, flux bias and/or input/output feedline) makes it possible to have transmission line connectors above the qubit plane instead of next to the qubit plane. It furthermore aids in decreasing the degree of on-chip routing.

In the case of spin qubits, a large plurality of low frequency gates is required. A large portion of the amount of gates per qubit in this case are electrostatic gates. An interposer according to the present embodiment promotes scaling up the number of spin qubits on a chip by incorporating the transmission lines of these electrostatic gates in the connection elements 37 of the interposer.

Thus, in general, by using an interposer with connection elements to connect the quantum computing circuit components, e.g. qubits, challenges issued by e.g. large qubit numbers such as on-chip routing difficulties of the transmission lines and spatial issues at the edges of the horizontal qubit plane due to wirebonding to printed circuit boards can be resolved. The vertical interposer also limits up-chain fan-out of the waveguides. This is due to the possibility of incorporating the macro-sized functional elements in the vertical elements of the vertical interposer.

For example, the wiring footprint 35A, i.e. the area that is taken up by the qubit and the related wiring for this qubit in a particular layer, can be at least partly limited to the three-dimensional volume between the wiring footprint 35A and its projection 35B in the plane parallel to the layer stack 31.

The connection elements 37 within the interposer can for example have one of the following functions: microwave drive (M), flux bias (F), feedline input/output (I/O), pump for the amplifiers or circulators, parametric amplifier, circulator, directional coupler or routing lines. It is also possible to combine multiple functions within one vertical element of the vertical interposer.

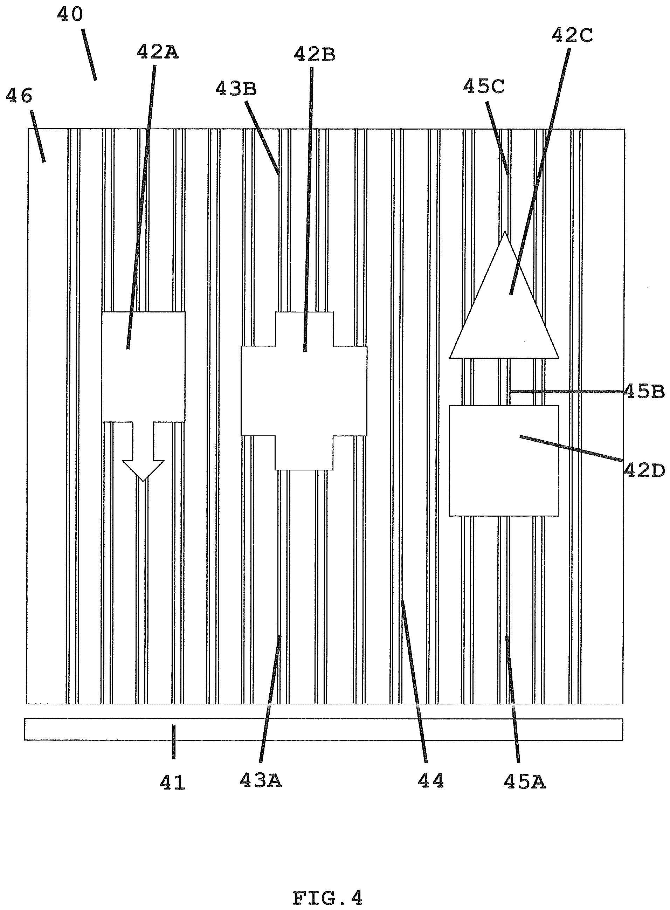

FIG. 4 schematically shows a part of a quantum computing apparatus 40 comprising an connection element 46 comprising one or multiple functional elements 42A-D according to an embodiment.

A functional element 42A-D is a circuit component which gets input from and/or sends output to the quantum computing circuit component within the layer stack 41. In other words, a functional element is a circuit component formed in the quantum computing apparatus so as to modify the input/output signal from the quantum computing circuit component, preferably a qubit. A functional element 42A-D can comprise for example a low pass filter, an attenuator, a DC-block, an IR filter, a directional coupler, a circulator, and/or an amplifier.

Transmission lines 43A,45A can connect a functional element 42B,D to the layer stack 41. A further transmission line 43B,45C then connects the functional element 42B,42C to a different part of the quantum computing apparatus 40 via the interface of the connection element 46 opposite of the interface connected to the layer stack 41. Transmission lines 45B can also electrically connect different functional elements 42C,42D within the connection element 46.

This makes it possible to have these functional elements above the qubit plane instead of next to the qubit plane. It furthermore aids in decreasing the degree of routing within the qubit plane.

The vertical interposer can thus also limit up-chain fan-out of the waveguides for qubits within the qubit plane. This is due to the possibility of incorporating the macro-sized functional elements in the vertical elements of the vertical interposer. Also, because of the ability of 3D shaping each vertical element to complex forms, and pattern superconducting films on them, the vertical interposer will also serve several microwave hygiene functions such as sub-sectioning large cavity volumes to smaller ones (pushing spurious modes to higher frequencies) and equalizing grounds across multiple horizontal elements.

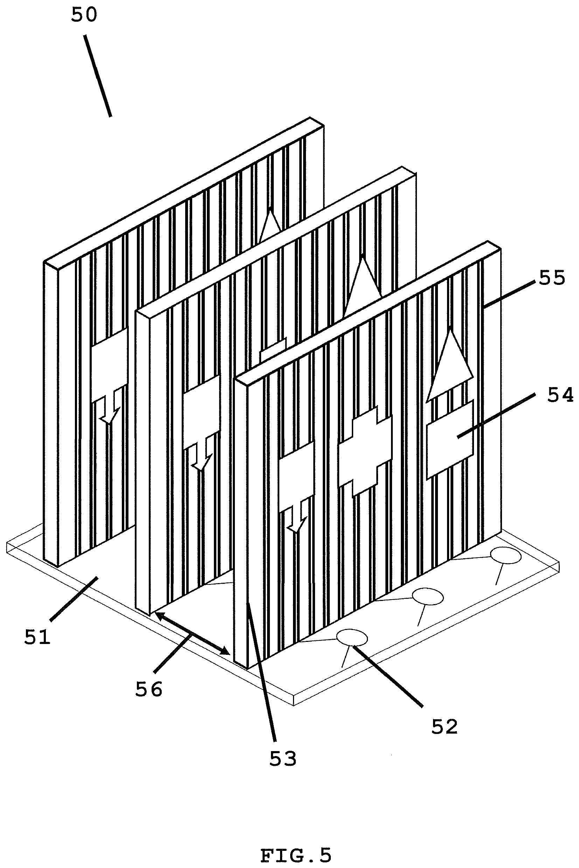

FIG. 5 schematically shows a perspective view of a part of a quantum computing apparatus 50 comprising a layer stack 51 with an interposer comprising an array of connection elements 53 with one or multiple functional elements 54 positioned thereon according to an embodiment.

Within the array of connection elements 53 in the interposer, there is a well-defined spacing (also called pitch) between each vertical element, related to the spacing of the quantum computing circuit components, e.g. qubits 52, comprised on or in the layer stack 51. For example, a spacing between qubits of 1 mm can be observed in a patterned layer of the layer stack 51 and the vertical elements 53 can then be formed e.g. at a particular location for each quantum computing circuit component such as to make a mechanical and/or electrical connection at that location. As mentioned before, in between the array's connection elements 53 in the interposer spacer elements can be placed.

Again, functional elements 54 and transmission lines 55 can be formed in one or more of the connection elements 53 of the interposer, and the connection elements 53 within the interposer can be different in terms of their built and/or functionality.

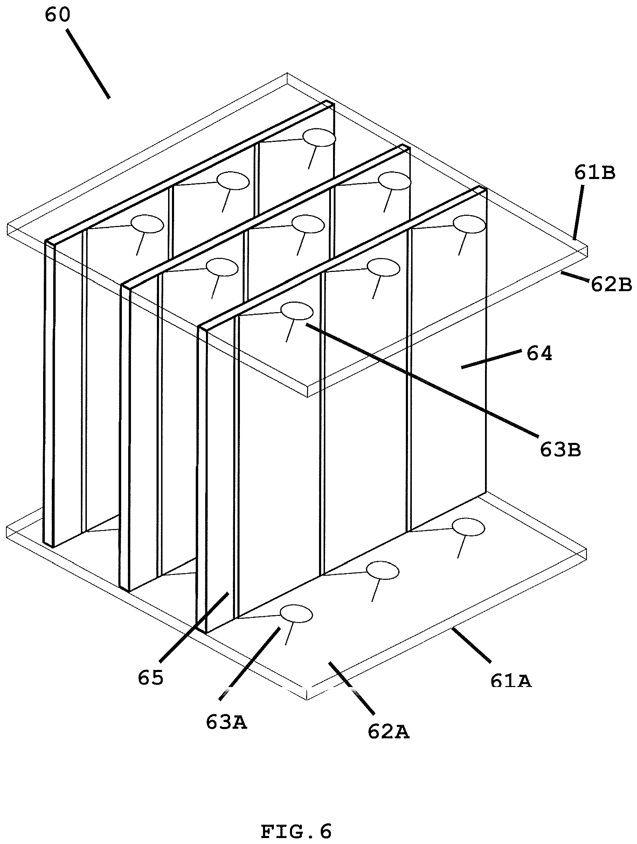

FIG. 6 schematically shows a perspective view of a part of a quantum computing apparatus 60 comprising two layer stacks 61A-B with an interposer formed in-between.

Transmission lines may be connected to the interface of the vertical interposer opposite of the interface connected to the horizontal plane possibly containing qubits to continue the signal path to other components of the quantum computer. In the present embodiment, the interposer is placed in-between two layer stacks 61A-B, possibly containing qubits, or other chip elements such as control electronics or transducers. The layer stacks 61A-B can be the same or different in terms of the amount of layers, the number of substrate layers and the material comprised therein, the number of patterned layers and the materials comprised therein. The layer stacks 61A-B each have a connection surface 62A,62B being the outermost layer of the layer stack 61A,61B facing the opposing layer stack 61B,61A.

In this way, quantum computing circuit components 63A,63B in different layer stacks 61A,61B can be electrically connected to one another via the one or more connection elements 64, via for example transmission lines 65 and/or functional elements (not shown).

Instead of a second layer stack, the interposer can also connect the layer stack 61A to another connectable circuit component, wherein the connection element is an intermediate link between the layer stack 61A, preferably the quantum computing circuit component 63A, and the connectable circuit component.

For example, the connectable circuit component can comprise a connectorized circuit, preferably a printed circuit board. The connectable circuit component can comprise other chip elements, for example control electronics, (flexible) cabling and/or transducers.

As mentioned, the connectable circuit component can comprise a second substrate layer and a second patterned layer adjacent and parallel to the second substrate layer such that the second substrate layer and the second patterned layer form a second layer stack 61B, wherein the second patterned layer forms at least one second quantum computing circuit component 63B. The second layer stack 61B can be substantially parallel to the layer stack 61A and at angle, preferably substantially orthogonal, to the connection element 64.

The second layer stack 61B can thus be positioned in a different plane than the plane in which the layer stack 61A is positioned, the connection element reaching from the plane in which the layer stack 61A is positioned to the plane where the second layer stack 61B is positioned.

Incorporating an interposer in this way may facilitate several novel quantum processor unit (QPU) architectures. One such option is thus a stacked plane architecture. Here several horizontal planes, for example layer stacks 61A, 61B, possibly containing quantum computing circuit components such as qubits or other chip elements, can be used in combination with one or several interposers. This type of QPU architecture facilitates scaling up qubit numbers in a QPU by three-dimensional expansion instead of just two-dimensional expansion. Thus, this allows the number of qubits in the same areal footprint to increase.

One possibility for a quantum computing apparatus, such as a quantum processor, employing a stacked architecture could be mounting several qubit planes containing signal vias on top of each other. To the interface of one or both of the outermost planes in the stack an interposer, non-parallel, preferably orthogonal, to the outermost plane in the stack, could then be connected. The transmission lines of the individual qubit planes could then be connected to the vertical interposer at the bottom and/or top of the stack through the signal vias in the adjacent horizontal planes possibly containing qubits. Instead of qubits, other quantum computing circuit components could be connected in this manner.

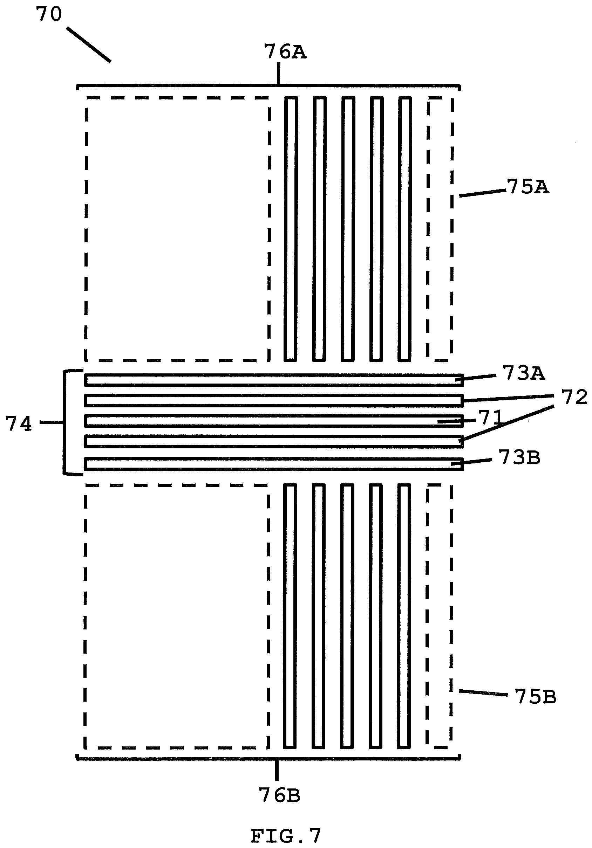

FIG. 7 schematically shows a part of a quantum computing apparatus 70 comprising a layer stack 74 with two interposers 76A,76B positioned thereon on either side of the layer stack 74 according to an embodiment.

The layer stack 74 can comprise one or multiple substrate layers 71 and one or multiple patterned layers 72 wherein each of the patterned layers 72 can comprise an electrical conductive material and can form at least one quantum computing circuit component.

The multiple layers of the layer stack 74 are formed on top of each other so as to be substantially parallel. An interposer 76A,76B comprising one or multiple connection elements 75A,75B can be mechanically connected to the layer stack 74 at both the top surface 73A and bottom surface 73B of the stack. The interposers 76A,76B do not have to be identical. The number of connection elements 75A,75B can vary, as well as the built and functionality of the connection elements 75A,75B.

Connecting a interposer 76A,76B at both the bottom and top of the stack facilitates beneficial ways of connecting quantum computing circuit components (e.g. qubits) such as for example having all input feedlines on one end of the stack and all output feedlines at the other. Thus, a second interposer 76B can be mechanically connected to the layer stack at an opposite end of the layer stack of where the first interposer 76A is mechanically connected to the layer stack. The input feedlines of the patterned layer in the layer stack 74 can thus for example be provided via the first interposer 76A, and the output feedlines of the patterned layer 74 can for example be provided via the second interposer 76B.

Another possible way of using a stacked architecture is using a stack where a vertical interposer and one or a plurality of planes possibly containing qubits are alternated. Thus, for example multiple layer stacks can be alternated with interposers. One can hereby create a 3D lattice of quantum computing circuit components, e.g. a 3D lattice of qubits.

By connecting two planes containing qubits together through an interposer in this manner, thus creating a 3D lattice, the degree of interconnectivity can be increased from that of the current 2D qubit plane lay-outs. This feature is beneficial for multiple possible applications. It leads to more computational power for certain quantum algorithms. Another possible application is error-correction. Operating a 3D qubit lattice gives the opportunity to work with a class of new 3D error-correction codes where the degree of interconnectivity is higher than four, which is the degree currently used for the 2D surface codes.

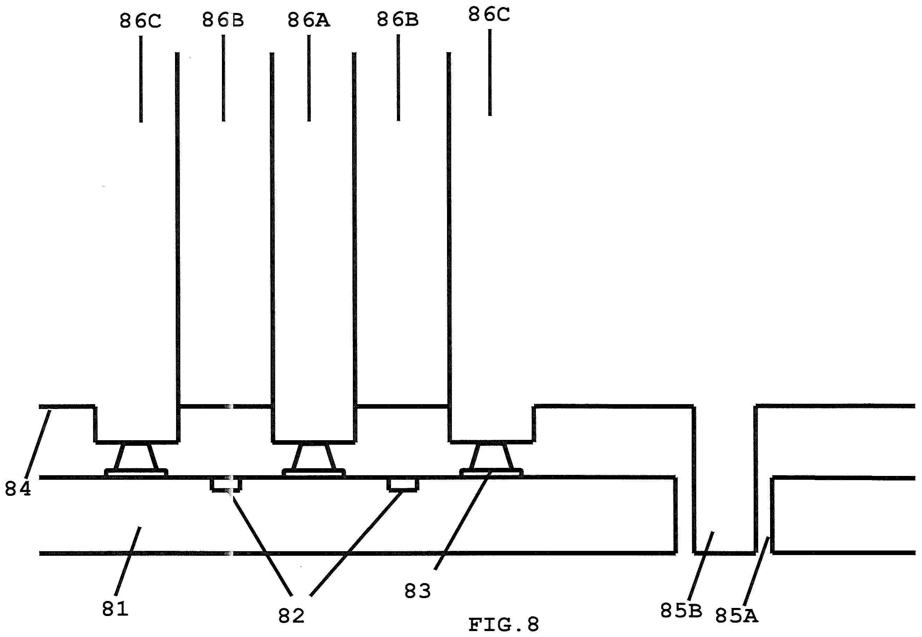

FIG. 8 schematically shows a part of a quantum computing apparatus 80 comprising mechanical 85A,85B and electrical connections 83 between the connection element 84 and the outermost layer 81 of the layer stack.

The surface of the connection element 84 in the interposer facing the outermost layer 81 of the layer stack, for example a qubit plane, and the outermost layer 81 itself can have a particular profile such that the interposer can couple (electrically and mechanically) to the outermost layer 81 of the layer stack, for example by using self-aligning structures. The outermost layer 81 can be a patterned layer, with a pattern 82 of conductive material formed thereon or therein. For example, the pattern 82 formed on or in the outermost layer 81 can form part of a quantum computing circuit component such as a qubit.

The geometry of the profile of the outermost layer 81 may include structures such as one or more recesses 85A. The geometry of the surface of the one or more connection elements 84 in the interposer facing the outermost layer 81 may include protrusions 85B, e.g. pins, which can couple to the recesses 85A in the outermost layer 81. Such a connection may be a self-aligning structure and can be incorporated to make the connected structure of the interposer and the layer stack compound more solid after fabrication.

The electrical connections between the connection element 84 and the outermost layer 81 of the layer stack can for example be done using conductive bumps 83 or other conductive connecting elements, for example made of indium. Indium has the advantage that it does not become brittle at very low temperatures, and is thus a good material choice when working e.g. with superconducting qubits as the quantum computing circuit component that is built into the layer stack.

The conductive bumps 83 can be formed at specific locations on the outermost layer 81, e.g. via soldering, electroplating, lamination and/or ball grid array stencil methods, and serve e.g. to send a signal to or from the quantum computing circuit component, for example a signal to or from a waveguide, and/or for example to connect the quantum computing circuit component in the layer stack to a functional element in the connection element 84. The conductive bumps 83 can be formed such that they are in contact with a ground line 86C or a transmission line 86A. The transmission line 86A and ground line 86C can be separated by a section 86B of the connection element 84 which has been removed by etching. In this exemplary embodiment, on the outermost layer 81, transmission line and ground are separated by pattern 82 which was removed by etching.

The profile in both the surface of the outermost layer 81 and that of the one or more connection elements 84 in the interposer, i.e. in one or both of the connection surfaces, may be created through techniques of lithography, deep reactive etching and/or photoablation. Both the mechanical and electrical geometry of the profiles may be created using one of these techniques.

Thus, the connection element 84 and the layer stack each can have a connection surface with a connection profile for mechanically and/or electrically coupling the connection element 84 to the layer stack. Preferably the connection surface of the layer stack is the outermost layer of the layer stack, more preferably the connection surface of the layer stack is the patterned layer. Furthermore, certain glues such as epoxys or stycast and soldering material can be used to further strengthen the mechanical connection between the layer stack and the connection elements 84.

The connection profile can comprise a coupling structure, preferably a recess, a protrusion, a coupling pin; more preferably the coupling structure can be self-aligning. The recess can be formed in the outermost layer 81 and subsequent layers underneath, depending on the requirements of the connection.

The connection profile of the (vertical) connection element 84 thus comprises protrusions (also called fingers or pins) deposited with superconducting and/or conducting material. These protrusions may make contact with the outer layer of the layer stack containing qubits. The protrusion associated with a transmission line makes contact either directly to this plane or by contact with through-and-through VIAs. The protrusion associated with the ground lines can form one uniform ground by connecting to the grounded parts of the outer layer of the layer stack. To ensure contact also at cryogenic conditions and to count for misalignment intolerances during the assembly, the tips of the protrusions can be covered with blobs of indium.

FIG. 14 schematically shows a connection profile 150 between the connection element and the layer stack comprising qubits. The connection profile of the connection element comprises protrusions (fingers/pins) 151 also deposited with superconducting and/or conducting material. The protrusions are making contact with the outer layer of the layer stack 154 containing preferably qubits. The finger 151 associated with the transmission line 153 makes contact either directly to this plane or by contact with through-and-through VIAs 155. The fingers associated with the ground lines can form one uniform ground by connecting to the grounded parts of the outer layer of the layer stack. To ensure contact also at cryogenic conditions and to count for misalignment intolerances during the assembly, the tips of the fingers 151 can be covered with blobs of indium (or other material that is soft and thermally conductive at cryogenic conditions) 152.

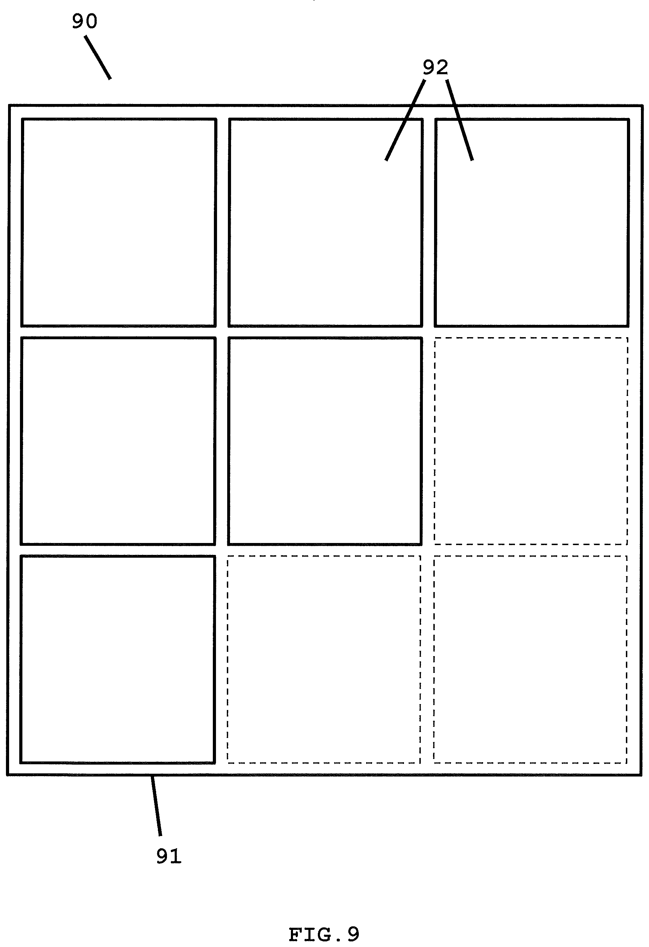

FIG. 9 schematically shows a part of a quantum computing apparatus 90 comprising a modular structure 91 with multiple modules 92 comprising one or more quantum computing circuit components.

Each module 92 may comprise a layer stack with one or more substrate layers and one or more patterned layers. The patterned layers may form one or more quantum computing circuit components. For example, one module 92 may comprise a qubit plane, with an array of qubits.

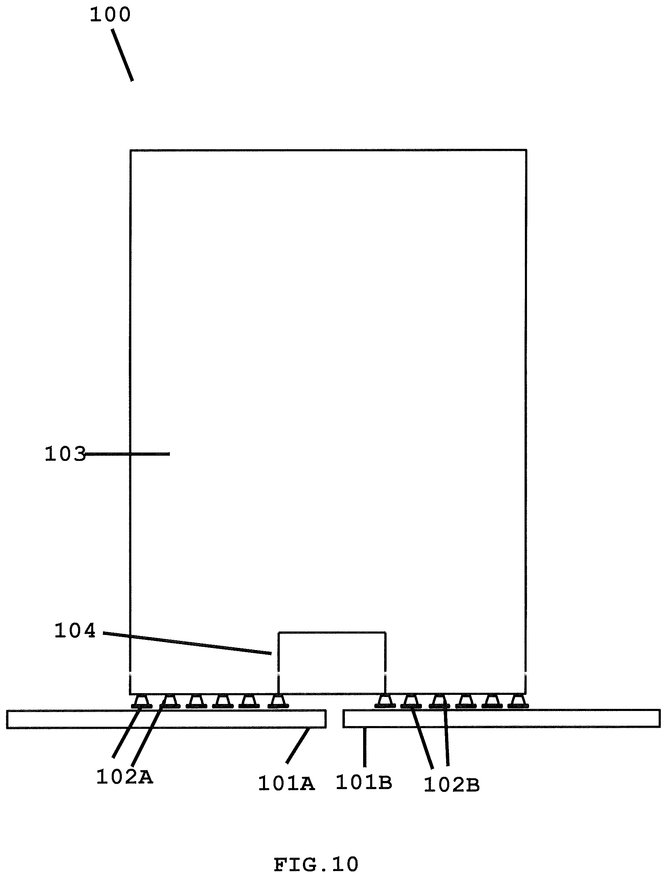

FIG. 10 schematically shows a part of a quantum computing apparatus 100 comprising an interposer with an connection element 103 which connects two layer stacks 101A, 101B comprising one or more quantum computing circuit components.

The two layer stacks 101A,101B can for example each be comprised within a different module of a modular structure. Conductive elements such as conductive bumps 102A, 102B may be used to electrically connect the layer stacks 101A,101B to the connection element 103 of the interposer. In this way the connection element, and thus the interposer, is connected to e.g. multiple qubit planes in different modules of the modular structure. For example, the qubit planes can be positioned in a staggered fashion with respect to the interposer. These multiple qubit planes can be coupled together through one or more routing lines 104 in the connection element 103 of the interposer. This makes a modular quantum processor possible.

This modular quantum processor structure allows an increase of the number of qubits whilst keeping the chip yield decoupled between the modules. This is because the probability of all qubits of a quantum processor structure working $P_{QPU}$ is equal to the following equation: $\prod_{i=0}^{m}\left(P_q\right)^{n_i}$, where $m$ is the number of modules in the quantum processor structure, $P_q$ is the average individual qubit yield and $n_i$ is the number of qubits in module $i$. For a quantum processor structure consisting of a single module with many qubits, the probability of all qubits working in that quantum processor structure thus approaches zero. If one instead makes a quantum processor structure from a large number of smaller modules, one can select the modules where all qubits on the module work before incorporating them in the structure. Therefore, $P_{QPU} \approx \prod_{i=0}^{m} 1$ after this intermediate selection step. The quantum processor structure yield can thus be increased.

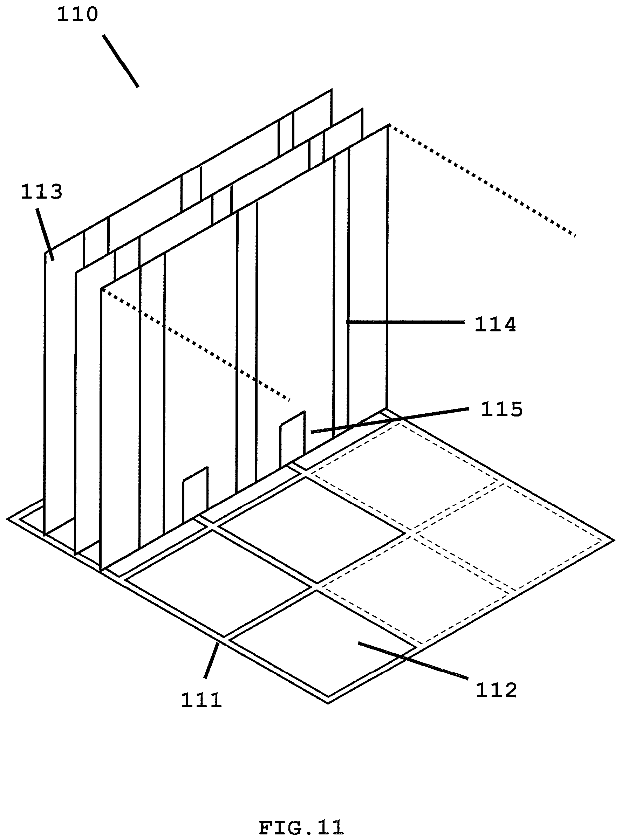

FIG. 11 schematically shows a part of a quantum computing apparatus 110 comprising an interposer comprising an array of connection elements 113 which connect multiple modules 112 within an modular structure 111, each module 112 comprising one or more quantum computing circuit components.

Again, the layer stacks are all positioned in substantially the same plane and can be electrically connected via routing lines 115 in the connection elements 113. Other transmission lines 114 or functional elements (not shown) can also be present in one or more of the connection elements.

The modular structure 111 can also have multiple interposers, each comprising an array of connection elements 113 which only cover a part of the modular structure 111, but together cover the entire modular structure 111 at least in terms of connectability. Another option is that each module 112 has its own interposer. Each of these interposers can comprise connection elements only spanning that specific module.

A module 112 within a modular structure 111, or indeed any layer stack can also comprise multiple interposers which are all mechanically and electrically connected to the same connection surface of the layer stack.

In general, to achieve maximal usability of a large qubit plane (or other quantum computing circuit components), intermediate selection can be applied.

A first method of intermediate selection may entail fabricating a large qubit plane. After the plane is fabricated, the functioning of each qubit is assessed for instance by optical microscopy or probe station measurements. Hereafter the largest possible area of the chip containing qubits without qubit failure is selected. Within this area, the transmission lines are re-routed. Lastly the area without qubit failure is cut out of the wafer.

A second method of intermediate selection may also entail fabricating a large qubit plane. After the plane is fabricated, the functioning of each qubit is assessed for instance by optical microscopy or probe station measurements. The parts of the qubit plane where qubit failure occurs are then cut out of the plane. The remaining elements are then connected to each other by means of airbridges or non-parallel, preferably orthogonal interposers.

It is especially beneficial to use tantalum nitride for the patterned layer of the qubit plane or planes, for example in the case of both spin qubits and superconducting qubits. Superconducting qubits made of tantalum have previously achieved long decoherence times, which is a measure of good qubit quality. For some superconducting elements, alloying the metal for the patterned layer with nitrogen results in a higher superconducting transition temperature (Tc) for the patterned layer such as in the case of Niobium. The use of tantalum nitride leads to long decoherence times, and in general longer decoherence times than when using tantalum. To fabricate such a patterned layer of tantalum nitride, atomic layer deposition and/or sputtering may be used to deposit tantalum nitride on the substrate layer.

In general, one can make a quantum computing apparatus, comprising a substrate layer and a patterned layer adjacent and parallel to the substrate layer such that the substrate layer and the patterned layer form a layer stack. The patterned layer can comprise or be made of an electrical conductive material and can form at least one quantum computing circuit component. The electrical conductive material can then comprise, or be, tantalum nitride. For example, the quantum computing circuit component can comprise tantalum nitride. In this way, longer decoherence times can be reached.

Superconducting tantalum qubits have already achieved very long decoherence times. A reason for this can be the absence (or reduction) of unwanted material defects at the interface, like two-level systems (TLS) which destroy coherence. Tantalum also only has one stable oxide ($Ta_2O_5$) which has the advantageous quality that only a thin oxide layer is formed at the surface before an equilibrium is reached. This effect also occurs in aluminium. Annealing the tantalum with nitrogen can be even more beneficial as nitrogen forms stronger bonds with tantalum than oxygen, and thus the oxide layer can be (strongly) reduced. As a rule of thumb, a thinner oxide layer is usually better.

In addition, for other superconducting materials annealing the metal of the patterned layer with nitrogen can increase the critical temperature of this metal. The critical temperature is the temperature at which superconducting effects occur, so a higher critical temperature of this metal is usually preferred. The same can be achieved with tantalum nitride.

Tantalum nitride can be deposited by means of ALD, reactive magnetron sputtering and PLD, among other methods. Because of the nitrogen bonds to the tantalum atoms, the surface of TaN films has reduced oxides compared to tantalum films, thus reducing the amount of defects (TLSs) exhibit by the metal-air interface at cryogenic temperatures and low power excitation typical of superconducting qubit operations. The substrate layer can be made from sapphire, silicon, BeO, AlN, quartz, and/or any other dielectric material. The quantum computing circuit component can comprise a qubit, preferably a superconducting qubit or a spin qubit. For example, part of or the entire patterned layer can be made out of TaN. Preferably, the Josephson junctions can be the part of the patterned layer which is not made out of TaN.

In general, a method of fabricating a quantum computing apparatus can comprise providing a substrate layer and depositing a patterned layer on top of the substrate layer using atomic layer deposition and/or sputtering with tantalum nitride. In this way, the patterned layer can comprise or be made from tantalum nitride. The patterned layer can be made to form at least one quantum computing circuit component, preferably a qubit, more preferably a superconducting qubit or a spin qubit. The substrate layer can be made from sapphire, silicon, BeO, AlN, quartz, and/or any other dielectric material.

One can perform a quantum computing operation, using a quantum computing apparatus comprising tantalum nitride as described above.

Both the horizontal and vertical element can be manufactured via traditional microfabrication techniques, for example as described below. Typically, a substrate can be cleaned and prepared for receiving metallization by means of for example sputtering, evaporation, ALD or MBE. Subsequently lithographic patterns can be defined for example by optical or e-beam techniques. Etching can for example be performed by dry etch, wet etch or combination. VIAs might be realized by means of DRIE or laser ablation, and its coating conformally realized by ALD. Elements can be separated from the starting substrate by dicing blade or laser ablation.

After the horizontal and vertical elements are individually fabricated, they can then be prepared for 3D assembly. This can involve an additional metal deposition (gold and Indium), and subsequent patterning. Lastly, alignment of horizontal and vertical elements is performed before for example thermal compression bonding.

Two or more of the above embodiments may be combined in any appropriate manner. The following clauses describe certain aspects of the invention.

Clause 1. A quantum computing apparatus, comprising: a substrate layer; a patterned layer adjacent and parallel to the substrate layer such that the substrate layer and the patterned layer form a layer stack, wherein the patterned layer comprises an electrically conductive material and wherein the layer stack forms multiple qubits; and an interposer comprising a rigid connection element mechanically connected to the layer stack, wherein the connection element is substantially planar and positioned in a non-parallel plane to the plane in which the substrate layer is formed, and wherein the connection element comprises a conductive element formed on or in the connection element, preferably a transmission line, for providing an electrical connection to the patterned layer.

Clause 2. The quantum computing apparatus of clause 1, wherein the connection element is of substantially rectangular or square shape.

Clause 3. The quantum computing apparatus of clause 1 or 2, wherein the interposer is electrically connected to the patterned layer galvanically, inductively or capacitively.

Clause 4. The quantum computing apparatus according to any of the preceding clauses, wherein the substrate layer is made from sapphire, silicon, BeO, AlN, quartz, and/or any other dielectric material, and/or wherein the patterned layer is made from a superconducting material such as Al, Nb, NbN, NbTiN, tantalum, preferably tantalum nitride.

Clause 5. The quantum computing apparatus according to any of the preceding clauses, wherein the patterned layer is formed by atomic layer deposition, evaporation, molecular-beam epitaxy and/or sputtering.

Clause 6. The quantum computing apparatus according to any of the preceding clauses, wherein the interposer, preferably the connection element, is made from the same material as used for the substrate layer.

Clause 7. The quantum computing apparatus according to any of the preceding clauses, wherein the connection element, comprises a connection substrate layer, or a connection substrate layer and a connection patterned layer adjacent and parallel to the connection substrate layer wherein the connection patterned layer comprises an electrically conductive material; preferably wherein the connection substrate layer is made from sapphire, silicon, BeO, AlN, quartz, and/or any other dielectric material, and/or preferably wherein the connection patterned layer is made from a superconducting material such as Al, Nb, NbN, NbTiN, tantalum, preferably tantalum; preferably wherein the connection patterned layer is coated with a conductive layer.

Clause 8. The quantum computing apparatus according to any of the preceding clauses, wherein the qubit comprises a superconducting qubit, a spin qubit, a trapped ion, or a neutral atom; and/or wherein the patterned layer further forms a quantum computing circuit, wherein the quantum computing circuit comprises a photonic quantum circuit and/or another chip element, preferably control electronics, readout circuit, amplifiers, filters and/or a transducer.

Clause 9. The quantum computing apparatus of any of the preceding clauses, wherein the connection element further comprises a functional element, the functional element being a circuit component which gets input from and/or sends output to the qubit and/or wherein the functional element modifies the input/output signal from the quantum computing circuit component preferably wherein the functional element comprises a low pass filter, an attenuator, a DC-block, an IR filter, a directional coupler, a routing line, a circulator, and/or an amplifier.

Clause 10. The quantum computing apparatus of clauses 7 and 9, wherein the connection patterned layer forms the functional element.

Clause 11. The quantum computing apparatus of any of the preceding clauses, wherein the connection element has at least one of the following functions: microwave drive, flux bias, feedline input/output, pump for the amplifier or circulator, parametric amplifier, circulator, directional coupler or routing lines.

Clause 12. The quantum computing apparatus of any of the preceding clauses, wherein routing to and/or from the qubit is at least partly done via the connection element.

Clause 13. The quantum computing apparatus according to any of the preceding clauses, wherein the interposer is connected directly to the patterned layer, or wherein the interposer is connected indirectly to the patterned layer, preferably through a via.

Clause 14. The quantum computing apparatus according to any of the preceding clauses, wherein the connection element and the layer stack each have a connection surface with a connection profile for mechanically and/or electrically coupling the connection element to the layer stack, preferably wherein the connection surface of the layer stack is an outermost layer of the layer stack, more preferably wherein the connection surface of the layer stack is the patterned layer, preferably wherein the connection profile comprises a coupling structure, preferably a recess, a protrusion, a coupling pin; preferably wherein the coupling structure is self-aligning.

Clause 15. The quantum computing apparatus of clause 14, wherein the connection profile formed on the connection surface is created through lithography, deep reactive etching and/or photoablation.

Clause 16. The quantum computing apparatus according to any of the preceding clauses, further comprising a connectable circuit component, wherein the connection element is an intermediate link between the layer stack, preferably the qubit, and the connectable circuit component; preferably wherein the connectable circuit component comprises a connectorized circuit, more preferably a printed circuit board or an array of waveguides.

Clause 17. The quantum computing apparatus of clause 16, wherein the connectable circuit component comprises a second layer stack, formed by at least a second substrate layer and a second patterned layer adjacent and parallel to the second substrate layer, wherein the second patterned layer forms at least one quantum computing circuit component.

Clause 18. The quantum computing apparatus of clause 17, wherein the second layer stack is substantially parallel to the layer stack and at an angle, preferably substantially orthogonal, to the connection element, preferably wherein the second layer stack is positioned in substantially the same plane as the layer stack and wherein the layer stack and the second layer stack are electrically connected via routing lines in the interposer; or wherein the second layer stack is positioned in a different plane than the plane in which the layer stack is positioned, the connection element reaching from the plane in which the layer stack is positioned to the plane where the second layer stack is positioned.

Clause 19. The quantum computing apparatus of any of clauses 16-18, wherein the connectable circuit component comprises, preferably wherein the second quantum computing circuit comprises, a qubit and/or other chip elements, preferably control electronics, readout circuit or transducers.

Clause 20. The quantum computing apparatus according to any of the preceding clauses, wherein the interposer comprises an array of connection elements which are substantially parallel to each other and at an angle, preferably substantially orthogonal, to the layer stack and wherein each connection element of the array is connected to the patterned layer, preferably wherein the connection elements are spaced with a particular spacing related to the spacing of the qubits on the horizontal plane.

Clause 21. The quantum computing apparatus of clause 20, wherein the interposer comprises at least one spacer element; preferably wherein the connection elements are aligned by the at least one spacer element; wherein the spacer element is mechanically connected to the connection element and/or the layer stack, preferably through a through-silicon via; wherein the at least one spacer element is positioned in a non-parallel plane to the substrate plane of the layer stack, preferably a substantially orthogonal plane to the substrate plane of the layer stack, more preferably wherein the spacer element is positioned in a plane parallel to the one or more connection elements; preferably wherein the interposer comprises multiple spacers, more preferably wherein the multiple spacers are alternating with the connection elements.

Clause 22. The quantum computing apparatus of clause 21, wherein the at least one spacer comprises a spacer substrate layer, or a spacer substrate layer and a spacer patterned layer adjacent and parallel to the spacer substrate layer wherein the spacer patterned layer comprises an electrically conductive material; preferably wherein the spacer substrate layer is made from sapphire, silicon, BeO, AlN, quartz, and/or any other dielectric material, and/or preferably wherein the spacer patterned layer is made from a superconducting material such as Al, Nb, NbN, NbTiN, tantalum, preferably tantalum nitride, preferably wherein the spacer patterned layer is coated with a conductive layer.

Clause 23. The quantum computing apparatus of clause 21 or 22, wherein the at least one spacer comprises a functional spacer element, preferably wherein the functional spacer element comprises a shield and/or wherein the at least one spacer comprises a waveguide with the connectable circuit component, for example a PCB.

Clause 24. The quantum computing apparatus of any of the preceding clauses, wherein the layer stack comprises multiple patterned layers deposited on one or more substrate layers, each patterned layer comprising a quantum circuit component, preferably a qubit.

Clause 25. The quantum computing apparatus of any of the preceding clauses, wherein the layers in the layer stack and/or layers in the connection element are connected through through-silicon via, preferably wherein the layer stack and/or the connection element comprises a through via and/or a blind via.

Clause 26. The quantum computing apparatus of any of the preceding clauses, wherein a second interposer is mechanically connected to the layer stack at an opposite end of the layer stack of where the interposer is mechanically connected to the layer stack, preferably wherein the input feedlines of the patterned layer are provided via the interposer, and the output feedlines of the patterned layer are provided via the second interposer.

Clause 27. The quantum computing apparatus of any of the preceding clauses, wherein multiple interposers are mechanically and electrically connected to a connection surface of the layer stack, and/or wherein multiple layer stacks are alternated with interposers.

Clause 28. A method of performing a quantum computing operation, using a quantum computing apparatus according to any of the preceding clauses.

Clause 29. A method of fabricating a quantum computing apparatus, comprising: providing a substrate; depositing a patterned layer on top of the substrate layer and parallel to the substrate layer such that the substrate layer and the patterned layer form a layer stack, wherein the patterned layer comprises an electrical conductive material and wherein the layer stack forms multiple qubits; mechanically connecting a rigid connection element comprised in an interposer to the layer stack, wherein the connection element is substantially planar and positioned in a non-parallel plane to the plane in which the substrate layer is formed; forming a conductive element on or in the connection element, preferably a transmission line, for providing an electrical connection to the patterned layer; and electrically coupling the conductive element to the patterned layer.

Clause 30. A quantum computing apparatus, comprising: a substrate layer; a patterned layer adjacent and parallel to the substrate layer such that the substrate layer and the patterned layer form a layer stack, wherein the patterned layer comprises an electrically conductive material and wherein the layer stack forms at least one quantum computing circuit component, preferably a ground plane, resonator, waveguide and/or qubit capacitor; wherein the electrically conductive material comprises tantalum nitride.

Clause 31. The quantum computing apparatus of clause 25, wherein the substrate layer is made from sapphire, silicon, BeO, AlN, quartz, and/or any other dielectric material; and/or wherein the quantum computing circuit component comprises a qubit, preferably a superconducting qubit or a spin qubit.

Clause 32. A method of fabricating a quantum computing apparatus, comprising: providing a substrate layer; depositing a patterned layer on top of the substrate layer using atomic layer deposition and/or sputtering with tantalum nitride, such that the patterned layer comprises tantalum nitride and forms at least one quantum computing circuit component, preferably a qubit, more preferably a superconducting qubit or a spin qubit; wherein preferably the substrate layer is made from sapphire, silicon, BeO, AlN, quartz, and/or any other dielectric material.

**Claims**

1. A quantum computing apparatus (10), comprising:

   a substrate layer (11);
   a patterned layer (12) adjacent and parallel to the substrate layer (11) such that the substrate layer (11) and the patterned layer (12) form a layer stack (14), wherein the patterned layer (12) comprises an electrically conductive material and wherein the layer stack (14) forms multiple qubits; and
   an interposer (16) comprising a connection element (15) mechanically and/or electrically connected to the layer stack (14);
   wherein the connection element (15) is substantially planar, has a footprint with curved sections on the layer stack, and/or is curved along its length;
   wherein the connection element is non-parallel to the plane in which the substrate layer (11) is formed; and
   wherein the connection element (15) comprises a conductive element formed on or in the connection element (15), preferably a transmission line, for providing an electrical connection to the patterned layer (12).

2. The quantum computing apparatus (10) of claim 1, wherein the connection element (15) further comprises a functional element;
   wherein the functional element is a circuit component which gets input from and/or sends output to the qubit and/or wherein the functional element modifies the input/output signal from the quantum computing circuit component.

3. The quantum computing apparatus (10) of claim 2, wherein the functional element comprises a low pass filter, an attenuator, a DC-block, an IR filter, a directional coupler, a routing line, a circulator, and/or an amplifier.

4. The quantum computing apparatus (10) of claims 2 or 3, wherein the transmission line connects the functional element to the layer stack and a second transmission line connects the functional element to a different part of the quantum computing apparatus via an interface of the connection element opposite of an interface connected to the layer stack or connects the functional element to a second functional element within the connection element.

5. The quantum computing apparatus (10) according to any of the preceding claims, wherein the qubit comprises a superconducting qubit, a spin qubit, a trapped ion, or a neutral atom;
   and/or wherein the patterned layer (12) further forms a quantum computing circuit, wherein the quantum computing circuit comprises a photonic quantum circuit and/or another chip element, preferably control electronics, readout circuit, amplifiers, filters and/or a transducer.

6. The quantum computing apparatus (10) of any of the preceding claims, wherein the connection element (15) has at least one of the following functions: microwave drive, flux bias, feedline input/output, pump for the amplifier or circulator, parametric amplifier, circulator, directional coupler or routing lines; and/or

   wherein the connection element (15) and the layer stack (14) each have a connection surface with a connection profile for mechanically and/or electrically coupling the connection element (15) to the layer stack (14), preferably wherein the connection surface of the layer stack (14) is an outermost layer of the layer stack (14), more preferably wherein the connection surface of the layer stack (14) is the patterned layer (12), preferably wherein the connection profile comprises a coupling structure, preferably a recess, a protrusion, a coupling pin; preferably wherein the coupling structure is self-aligning, preferably wherein the connection profile formed on the connection surface is created through lithography, deep reactive etching and/or photoablation; and/or

wherein routing to and/or from the qubit is at least partly done via the connection element (15).

7. The quantum computing apparatus (10) according to any of the preceding claims, further comprising a connectable circuit component, wherein the connection element (15) is an intermediate link between the layer stack (14), preferably the qubit, and the connectable circuit component; preferably wherein the connectable circuit component comprises a connectorized circuit, more preferably a printed circuit board or an array of waveguides.

8. The quantum computing apparatus (10) of claim 7, wherein the connectable circuit component comprises a second layer stack, formed by at least a second substrate layer (11) and a second patterned layer (12) adjacent and parallel to the second substrate layer, wherein the second patterned layer (12) forms at least one quantum computing circuit component; and preferably

wherein the second layer stack is substantially parallel to the layer stack (14) and at an angle, preferably substantially orthogonal, to the connection element (15), preferably wherein the second layer stack is positioned in substantially the same plane as the layer stack (14) and wherein the layer stack (14) and the second layer stack are electrically connected via routing lines in the interposer (16); or wherein the second layer stack is positioned in a different plane than the plane in which the layer stack (14) is positioned, the connection element (15) reaching from the plane in which the layer stack (14) is positioned to the plane where the second layer stack is positioned.

9. The quantum computing apparatus (10) of claim 7 or claim 8, wherein the connectable circuit component comprises, preferably wherein the second quantum computing circuit comprises, a qubit and/or other chip elements, preferably control electronics, cabling, flexible cabling, readout circuit or transducers.

10. The quantum computing apparatus (10) according to any of the preceding claims, wherein the interposer (16) comprises an array of connection elements (15) which are substantially parallel to each other and at an angle, preferably substantially orthogonal, to the layer stack (14) and wherein each connection element (15) of the array is connected to the patterned layer (12), preferably wherein the connection elements (15) are spaced with a particular spacing related to the spacing of the qubits on the horizontal plane.

11. The quantum computing apparatus (10) of claim 10, wherein the interposer (16) comprises at least one spacer element;

preferably wherein the connection elements (15) are aligned by the at least one spacer element; wherein the spacer element is mechanically connected to the connection element (15) and/or the layer stack (14), preferably through a through-silicon via; wherein the at least one spacer comprises a functional spacer element, preferably wherein the functional spacer element comprises a shield and/or wherein the at least one spacer comprises a waveguide with the connectable circuit component, for example a PCB.

12. The quantum computing apparatus (10) of any of the preceding claims, wherein the layer stack (14) comprises multiple patterned layers (12) deposited on one or more substrate layers, each patterned layer (12) comprising a quantum circuit component, preferably a qubit; and/or wherein the layers in the layer stack (14) and/or layers in the connection element (15) are connected through through-silicon via, more preferably wherein the layer stack (14) and/or the connection element (15) comprises a through via and/or a blind via.

13. The quantum computing apparatus (10) of any of the preceding claims, wherein the interposer limits upchain fan-out of waveguides; preferably wherein a wiring footprint (35A), which is the area that is taken up by the qubit and the related wiring for this qubit in a particular layer, is limited to the three-dimensional volume between the wiring footprint (35A) and its projection (35B) in the plane parallel to the layer stack (31).

14. A method of performing a quantum computing operation, using a quantum computing apparatus (10) according to any of the preceding claims.

15. A method of fabricating a quantum computing apparatus (10), comprising:

providing a substrate; depositing a patterned layer (12) on top of the substrate layer (11) and parallel to the substrate layer (11) such that the substrate layer (11) and the patterned layer (12) form a layer stack (14), wherein the patterned layer (12) comprises an electrical conductive material and wherein the layer stack (14) forms multiple qubits; mechanically and/or electrically connecting a connection element (15) comprised in an interposer (16) to the layer stack (14), wherein the connection element (15) is substantially planar, has a footprint with curved sections on the layer stack, and/or is curved along its length; wherein the connection element is non-parallel to the plane in which the substrate layer (11) is formed; forming a conductive element on or in the connection element (15), preferably a transmission line, for providing an electrical connection to the patterned layer (12); and electrically coupling the conductive element to the patterned layer (12).

FIG.1

FIG.2

FIG.3

FIG.4

FIG.5

FIG.6

FIG.7

EP 4 645 179 A2

86C    86B    86A    86B    86C

84

81    82    83    85B  85A

FIG.8

FIG.9

FIG.10

110

113

114

115

111

112

FIG.11

120

121        122

121

FIG.12

130

132

134 FIG.13A

131

133

140A

140B

141

FIG.13B

150

151

152

154

155

153

FIG.14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3427310 B1